Europäisches Patentamt

European Patent Office

Office européen des brevets

(19)

(11) Numéro de publication : **0 393 092 B1**

(12) # FASCICULE DE BREVET EUROPEEN

(45) Date de publication du fascicule du brevet :
**27.01.93 Bulletin 93/04**

(51) Int. Cl.⁵ : **G01R 33/20,** G01R 33/34, G01R 33/38

(21) Numéro de dépôt : **88910048.3**

(22) Date de dépôt : **10.11.88**

(86) Numéro de dépôt international :
**PCT/FR88/00557**

(87) Numéro de publication internationale :
**WO 89/04494 18.05.89 Gazette 89/11**

(54) **DISPOSITIF D'IMAGERIE RMN, PROCEDE DE CORRECTION D'INHOMOGENEITE ET PROCEDE DE REALISATION D'AIMANTS MIS EN OEUVRE DANS LE DISPOSITIF.**

(30) Priorité : **13.11.87 FR 8715670**

(43) Date de publication de la demande :
**24.10.90 Bulletin 90/43**

(45) Mention de la délivrance du brevet :
**27.01.93 Bulletin 93/04**

(84) Etats contractants désignés :
**DE GB IT NL**

(56) Documents cités :
**EP-A- 0 167 059
EP-A- 0 171 831
EP-A- 0 216 404
EP-A- 0 222 281
WO-A-88/08126
FR-A- 2 549 281**

(56) Documents cités :
**GB-A- 2 184 243
Review of Scientific Instruments, volume 56, no. 1, janvier 1985, (New York, US), D.I. Hoult et al.: "Shimming asuperconducting nuclear-magnetic-resonance imaging magnet with steel", pages 131-135**

(73) Titulaire : **CENTRE NATIONAL DE LA RECHERCHE SCIENTIFIQUE (CNRS)
15, Quai Anatole France
F-75700 Paris Cedex 07 (FR)**

(72) Inventeur : **AUBERT, Guy
26, cours de la Libération
F-38100 Grenoble (FR)**

(74) Mandataire : **Schmit, Christian Norbert Marie et al
Cabinet Ballot-Schmit 7, rue Le Sueur
F-75116 Paris (FR)**

EP 0 393 092 B1

Jouve, 18, rue Saint-Denis, 75001 PARIS

## Description

La présente invention a pour objet un dispositif de correction par des éléments magnétiques des inhomogénéités du champ magnétique produit par un aimant. Elle concerne particulièrement un dispositif d'imagerie par RMN dire IRM, un procédé de correction d'inhomogénéité et un procédé de réalisation d'aimants mis en oeuvre dans le dispositif. L'invention trouve son application particulièrement dans le domaine médical où des aimants sont utilisés dans les méthodes d'imagerie par résonance magnétique nucléaire. Elle peut néanmoins trouver son application dans d'autres domaines, notamment dans celui de la recherche scientifique où l'on engendre des champs intenses avec des aimants.

La résonance magnétique est un phénomène d'oscillation du moment magnétique des noyaux des atomes ou molécules d'un corps, à une fréquence qui dépend de l'intensité d'un champ magnétique dans lequel baigne ce corps. Il en ressort que si l'intensité du champ magnétique varie, la fréquence du phénomène de résonance varie également. Aussi, pour des raisons technologiques et techniques, il est de la plus haute importance que le champ produit par l'aimant soit très homogène dans sa zone d'intérêt. L'homogénéité requise est couramment de l'ordre de quelques parties par millions dans le domaine médical, voire de quelques parties par milliard dans le domaine scientifique. Pour arriver à ce but, on essaye de construire des aimants donnant un champ le plus parfaitement homogène.

Malheureusement, quel que soit le soin apporté à la construction des aimants, leur réalisation n'est jamais aussi parfaite que la théorie qui a conduit à leur calcul. Par ailleurs, même si ce défaut peut être éliminé, l'aimant pour être utilisé doit matériellement être placé en un endroit donné. Or aucune des régions de l'espace, dans un environnement industriel ou urbain, n'est totalement exempte d'éléments magnétiques perturbateurs. Il en résulte qu'une fois l'aimant installé sur le site, le champ qu'il produit dans une zone d'intérêt présente des inhomogénéités qu'il est nécessaire de corriger.

Le principe de la correction des inhomogénéités de champs est celui de la superposition : on ajoute des bobines, des pièces magnétiques, ou tous autres moyens permettant de corriger les imperfections du champ principal et d'obtenir un champ global homogène dans la zone d'intérêt. Une méthode connue, pour corriger les inhomogénéités du champ magnétique produit par un aimant, consiste à utiliser des éléments magnétiques tels que des barres aimantables, par exemple en fer doux, que l'on place dans l'environnement de l'aimant, et qui exercent leur influence dans une zone d'intérêt de l'aimant de manière à corriger les inhomogénéités du champ dans cette zone.

Un tel procédé est commenté dans un article de Revue Sci. Instrum. de JANVIER 1985, dû à MM. D.I-.HOULT, et D. LEE, intitulé "Shimming a superconducting nuclear- magnetic-resonance imaging magnet with steel", page 131 à 135. L'article se rapporte particulièrement a un amant pour appareil d'imagerie par résonance magnétique nicléaire. L'aimant a la forme d'un cylindre circulaire, à l'intérieur duquel est située la zone d'intérêt dont le centre est placé sur l'axe de l'aimant ; le champ magnétique produit par l'aimant étant à l'intérieur de ce dernier sensiblement parallèle à l'axe de l'aimant. Ce document décrit en détail une méthode de calcul qui permet de déterminer les dimensions et la position d'une ou de plusieurs barres magnétiques d'acier doux autour de l'axe de l'aimant, en fonction d'un point du volume d'intérêt où une inhomogénéité du champ est à corriger ; la longueur de ces barres magnétiques correctrices étant parallèle à l'axe de l'aimant.

Un tel procédé, malgré sa relative complexité, permet de corriger efficacement des inhomogénéités que peut comporter le champ magnétique dans le volume d'intérêt, en disposant une ou des barres magnétiques correctrices dont la section, la longueur et la position par rapport au volume d'intérêt sont déterminées sur la base des calculs connus, et tels que par exemple indiqués notamment dans l'article ci-dessus mentionné. Mais tel qu'il est connu, ce procédé présente l'inconvénient d'être difficilement applicable dans le cadre d'une fabrication industrielle d'aimants : en effet, compte tenu particulièrement, d'une part des tolérances de fabrication qui peuvent introduire d'un aimant à un autre des différences entre les champs magnétiques produits par ces aimants, et compte tenu d'autre part, des éléments qui sur le site d'installation sont susceptibles de perturber le champ magnétique, il est nécessaire de redéfinir à la fois la longueur, la section transversale et la position des barres magnétiques correctrices quand l'aimant est déja installé sur le site, c'est-à-dire que les barres magnétiques doivent être taillées et positionnées sur mesure pour chaque application.

D'autre part, la Demanderesse a décrit dans le Brevet FR-A-86 18358, un dispositif de correction d'inhomogénéité de champ magnétique dans un aimant utilisant des barres magnétiques. Ces barres pouvant être logées dans des tubes peuvent prendre n'importe quelle position parallèlement au champ, de plus les longueurs peuvent être quelconques. Ce procédé présente l'inconvénient d'occuper une certaine place A l'intérieur du volume utile de l'aimant.

Dans le Brevet FR-A-86 06862 la Demanderesse a décrit un dispositif de correction d'inhomogénéité de champ magnétique utilisant des éléments magnétiques orientables. Dans ce cas, les calculs nécessaires à la détermination de la configuration des aimants présentant une homogénéité de champ désirée sont très longs et leur installation dans les positions et les orientations calculées n'est pas simple à mettre en oeuvre. On connait également du document EP-A-0 167 059 un dispositif correspondant au préambule de la revendication 1.

Le dispositif selon la présente invention comporte des ouvertures ou conduits à sections carrées ce qui permet de limiter certains paramètres de position et d'orientation des aimants et par suite de simplifier les calculs déterminant la configuration des aimants permettant une bonne correction d'inhomogénéité de champ magnétique. Dans le dispositif selon la présente invention, on utilise des aimants de forme parallélépipède rectangle, ou avantageusement cube, ayant des aimantations prédéterminées en direction et en amplitude. Ainsi, on a quantifié l'aimantation susceptible d'être mise en oeuvre dans les corrections d'inhomogénéité des champs magnétiques. Cette quantification permet, d'une part de simplifier les calculs, et d'autre part de disposer d'aimants standards, préparés en usine, pour les corrections réalisées sur site.

Le principe de l'invention réside dans cette quantification, au moins dans une dimension des positions que peuvent prendre les aimants de correction.

Par exemple, un aimant cubique peut prendre six orientations à l'intérieur d'un conduit à section carrée. On dispose d'aimants possédant diverses amplitudes de moment magnétique. Dans le calcul d'optimisation l'homogénéisation du champ magnétique les valeurs des moments magnétiques des aimants de corrections sont rentrées en temps que contrainte. Cela limite le nombre de possibilités à analyser, et par suite la quantité de calculs à effectuer Par contre, la disposition des cubes à l'intérieur des conduits reste ajustable de façon continue dans la mesure où on dispose des entretoises de longueur variable.

L'invention n'est pas limitée à la correction d'inhomogénéité de champ magnétique. Elle permet toute modification sur un champ magnétique statique que l'on peut désirer, comme par exemple la réalisation de gradient de champ magnétique statique.

L'invention a principalement pour objet le dispositif et le procédé tel que décrit dans les revendications.

L'invention sera mieux comprise au moyen de la description ci-après et des figures annexées données comme des exemples non limitatifs parmi lesquelles :
- la figure 1 est un schéma explicatif du principe de correction d'inhomogénéité de champ magnétique du type connu ;
- la figure 2 est un schéma explicatif d'une première correction élémentaire possible avec je dispositif selon la présente invention ;
- la figure 3 est un schéma explicatif d'une deuxième correction élémentaire possible avec le dispositif selon la présente invention ;
- la figure 4 est un schéma explicatif d'une troisième correction élémentaire possible avec le dispositif selon la présente invention ;
- la figure 5 est un schéma explicatif d'une quatrième correction élémentaire possible avec le dispositif selon la présente invention ;
- la figure 6 est un schéma explicatif d'une cinquième correction élémentaire possible avec le dispositif selon la présente invention ;
- la figure 7 est un schéma explicatif d'une sixième correction élémentaire possible avec le dispositif selon la présente invention ;
- la figure 8 est un schéma explicatif d'une septième correction élémentaire possible avec le dispositif selon la présente invention ;
- la figure 9 est le schéma explicatif d'une huitième correction élémentaire possible avec le dispositif selon la présente invention ;
- la figure 10 est le schéma explicatif d'une neuvième correction élémentaire possible avec le dispositif selon la présente invention ;
- la figure 11 est le schéma explicatif d'une dixième correction élémentaire possible avec le dispositif selon la présente invention ;
- la figure 12 est un schéma d'un exemple de réalisation d'un dispositif d'imagerie par résonance magnétique nucléaire selon la présente invention ;
- la figure 13 est un schéma de réalisation d'un aimant susceptible d'être mis en oeuvre dans le dispositif selon la présente invention.

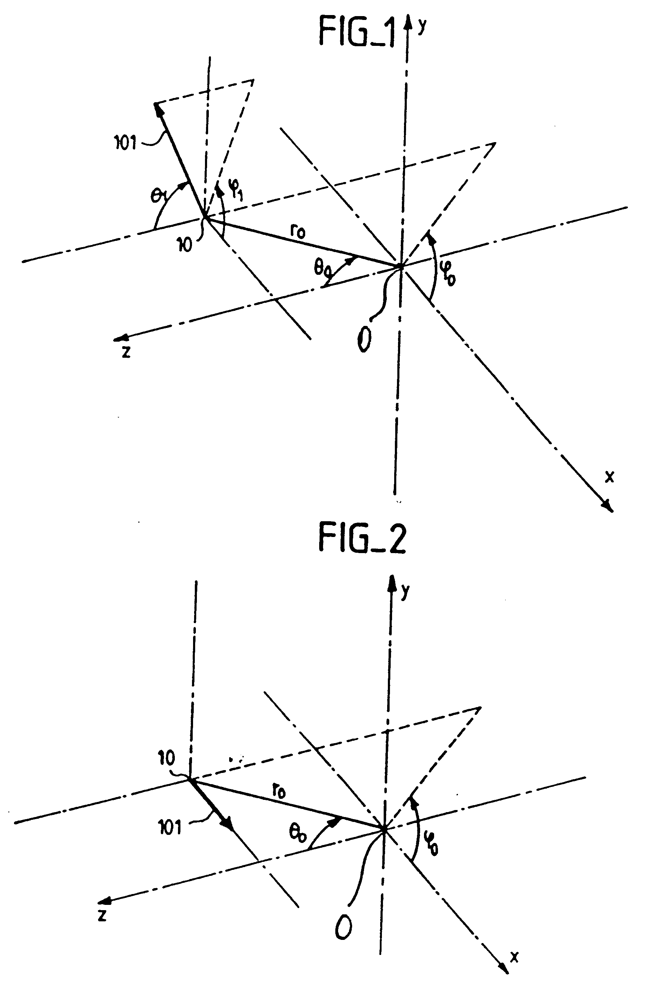

Sur les figures 1 à 13 on a utilisé les mêmes références pour désigner les mêmes éléments.

Sur la figure 1, on peut voir le principe de correction d'inhomogénéité de champ magnétique par exemple à l'intérieur d'un aimant engendrant un champ magnétique continu de forte intensité $B_0$ d'un dispositif d'imagerie par résonance magnétique nucléaire.

Soit O le centre de l'aimant, et O x,y,z, un repère orthonormé lié à l'aimant. Par exemple, l'axe z correspond à l'axe de l'aimant. Une correction d'inhomogénéité du champ de l'aimant est caractérisée par l'endroit où l'on applique la correction, avec, par exemple, un aimant permanent 10, ainsi que l'orientation et l'amplitude 101 de l'aimantation de l'aimant permanent 10. Sur la figure 1, la position de l'aimant 10 est repérée en coordonnées sphériques par $r_0$, $\theta_0$, $\varphi_0$, l'orientation de l'aimantation de l'aimant 10 est repérée par les angles $\theta 1$ et $\varphi 1$ la longueur du vecteur 101 déterminant l'amplitude de l'aimantation. On se retrouve donc avec un système à six degrés de liberté pour chaque aimant nécessitant un temps de calcul, par exemple sur ordinateur, extrêmement long pour déterminer la configuration nécessaire pour réaliser la correction désirée.

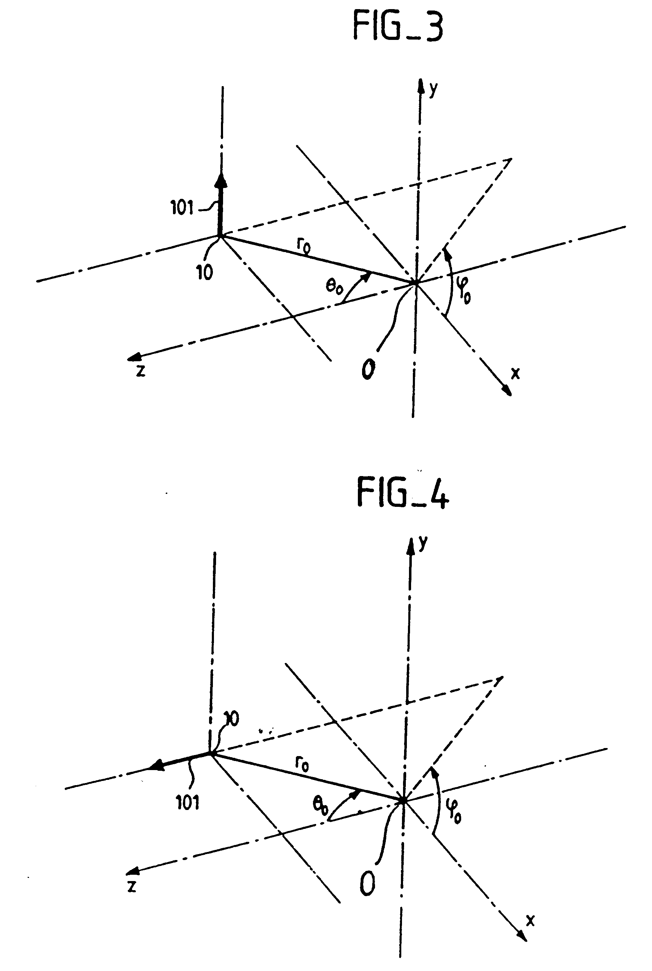

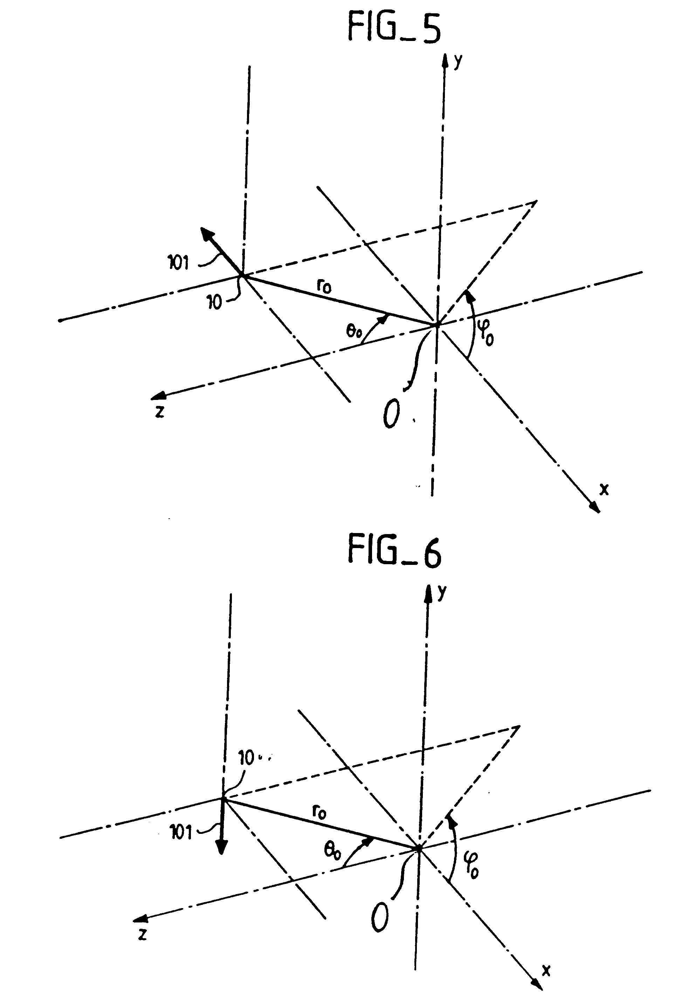

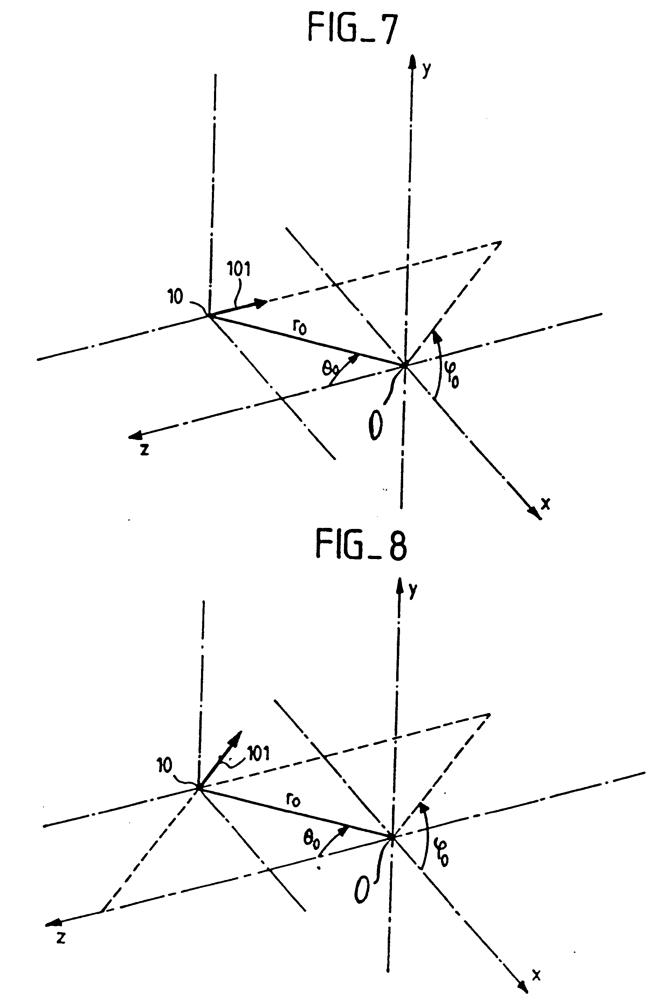

Sur la figure 2, on peut voir un premier exemple de correction élémentaire susceptible d'être mis en oeuvre dans le dispositif selon la présente invention. Les aimants élémentaires 10 sont placés dans des ouvertures à section rectangulaire ou avantageusement carrée parallèles à l'axe z. Avantageusement, ces ouvertures sont placées à une distance fixe de l'axe z. Ainsi, les calculs sont limités, car les aimants 10 ne pourront pas prendre n'importe quelle position dans l'espace. De plus, les aimants 10 étant des parallélépipèdes rectangles ou des cubes leur aimantation ne peut prendre qu'un nombre limité de positions. Par exemple, l'aimantation est perpendiculaire à l'une des faces du cube. Dans ce cas, selon l'orientation du cube l'aimantation 101 ne peut prendre que six positions. Si par exemple, les parois des conduits sont parallèles aux plans xoz et yoz, les six positions correspondront à une aimantation 101 positive selon les axes des x telle qu'illustrée sur la figure 2 ; à une aimantation 101 positive selon l'axe des y telle qu'illustrée sur la figure 3 ; à une aimantation 101 positive selon l'axe des z, telle qu'illustrée sur la figure 4 ; à une aimantation négative 101 selon l'axe des x, telle qu'illustrée sur la figure 5 ; à une aimantation négative selon l'axe des y, telle qu'illustrée sur la figure 6 ou enfin, à une aimantation 101 négative selon l'axe des z telle qu'illustrée sur la figure 7. Si, dans une autre configuration possible, deux des parois des conduits sont disposées tangentiellement à un cylindre d'axe oz, on peut toujours obtenir les orientations ± z représentées aux figures 4 et 7 et, au lieu des orientations ± x des figures 2 et 5 et ± y des figures 3 et 6, les orientations représentées aux figures 8, 9, 10, 11 qui correspondent à

$\theta_1 = \pi/2$ et $\varphi_1 = \varphi_o, \varphi_o + \pi, \varphi_o - \pi/2, \varphi_o + \pi/2$ respectivement.

L'amplitude de l'aimantation 101 dépend du cube utilisé. Sur la figure 8, on peut voir un exemple de réalisation d'un dispositif d'imagerie par résonance magnétique nucléaire selon la présente invention. La représentation de l'appareil 1 d'IRM est limitée sur la figure 12 aux éléments nécessaires à la compréhension de l'invention. L'appareil d'IRM 1 a la forme extérieure générale d'un cylindre circulaire et comporte un aimant 2 de forme cylindrique également, dont l'axe Z constitue également l'axe longitudinal de l'appareil d'IRM 1. L'aimant 2 est constitué, par exemple, par un agencement de bobines électriques (non représentées) de type connu. L'aimant 2 produit un champ magnétique $B_O$ qui est orienté, à l'intérieur de l'aimant 2, selon l'axe Z de ce dernier. Le long de l'axe Z de l'aimant, un espace intérieur libre 4 constitue un tunnel destiné à recevoir un patient (non représenté) à examiner. Selon un arrangement traditionnel, l'appareil d'IRM 1 comporte autour du tunnel 4 différents éléments (non représentés) : antennes radiofréquence et bobines de gradients. Il est bien entendu que l'appareil d'imagerie par résonance magnétique nucléaire 1 comporte des dispositifs de traitement du signal et de moyens de visualisation, non représentés sur la figure 12.

Avantageusement, les ouvertures 102 à section rectangulaire ou avantageusement, comme représenté sur la figure 12, carrée, sont positionnées à l'extérieur de l'aimant 2 et sur son pourtour. De cette façon, les aimants placés dans les ouvertures 102 ne sont que faiblement influencées par le champ magnétique créé par l'aimant 2. Ainsi, l'aimant 2 ne modifie pas l'aimantation des aimants permanents R susceptibles d'être placés dans les ouvertures 102.

Dans une première variante de réalisation, les aimants permanents 8 assurent toutes les corrections de l'homogénéité du champ magnétique $B_0$.

Dans une seconde variante de réalisation, les aimants permanents 8 sont associés , à des bobines de correction électrique classiques pour assurer la correction.

Avantageusement, les aimants permanents 8 assurent les corrections radiales de l'inhomogénéité du champ magnétique $B_0$, les bobines de correction électrique classiques assurant les corrections axiales, le long de l'axe z de l'inhomogénéité du champ magnétique $B_0$.

Dans une première variante de réalisation du dispositif comportant une association d'éléments à correction électrique et de l'aimant permanent 8 pour corriger les inhomogénéités du champ magnétique les bobines de correction électrique sont reliés à un générateur de courant.

Le nombre et la section des ouvertures 102 dépendent du type de correction à effectuer et du degré de correction désiré. On utilise par exemple 6,8 ouvertures 102 ou plus réparties régulièrement sur le pourtour de l'aimant 2.

Pour effectuer les corrections selon la présente invention, on effectue donc les mesures du champ réel à l'intérieur de l'aimant 1, on calcule les corrections nécessaires pour obtenir une homogénéité désirée et l'on insère les aimants permanents 8 dans les ouvertures 102 de façon à les placer dans les positions permettant d'obtenir les corrections désirées. Sur la figure 12 seuls quelques aimants permanents 8 ont été illustrés. Il est bien entendu que l'on utilise le nombre d'aimants 8 nécessaire à la correction désirée. Des entretoises permettent le positionnement précis et stable des aimants permanents 8. Les entretoises ne sont pas représentées sur la figure 8. Il est possible, une fois les corrections réalisées de vérifier l'homogénéité du champ magnétique à l'intérieur de l'aimant 1.

On peut utiliser tout type de mesure connue de champ magnétique à l'intérieur de l'aimant 1. Toutefois, il est avantageux d'utiliser le dispositif d'exploitation du volume intérieur d'un cylindre et système d'investigation muni de ce dispositif tel que décrit dans le brevet français FR-A-86 04591.

Il est possible d'utiliser une quelconque méthode connue pour déterminer les corrections d'inhomogénéité de champ magnétique pour déterminer les valeurs et les positions des aimants permanents 8.

Avantageusement, on utilise la méthode décrite dans le brevet FR-A-86 06861 non encore publié.

Dans cette méthode, on calcule une expression analytique du champ sous la forme d'une décomposition en harmoniques sphériques. On calcule également des décompositions en harmoniques sphériques similaires mais relatives au champ créé par chacun des moyens de correction dont on dispose pour corriger ce champ. On effectue ensuite une combinaison algébrique des expressions analytiques des moyens de correction de manière à produire une expression analytique de correction qui, additionnée à l'expression analytique du champ réel la transforme en une expression analytique correspondant à un champ magnétique idéal.

Il est à noter que la limitation des possibilités d'orientation des aimants 8 pour corriger l'inhomogénéité du champ magnétique ne présente pas en pratique de limitation des corrections elles-mêmes, tout en réduisant la quantité de calculs nécessaires à la mise en oeuvre du procédé.

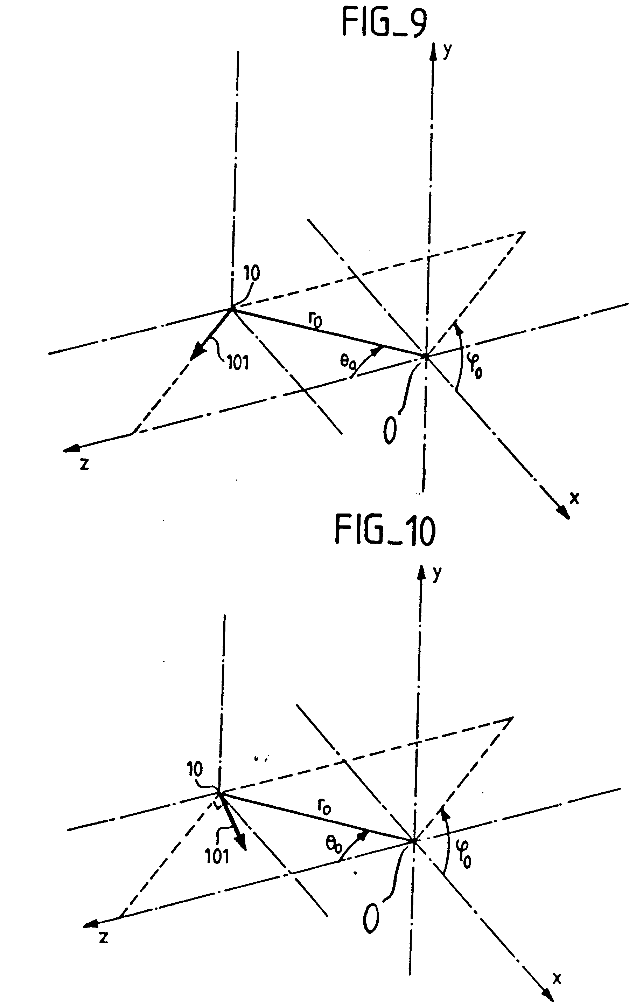

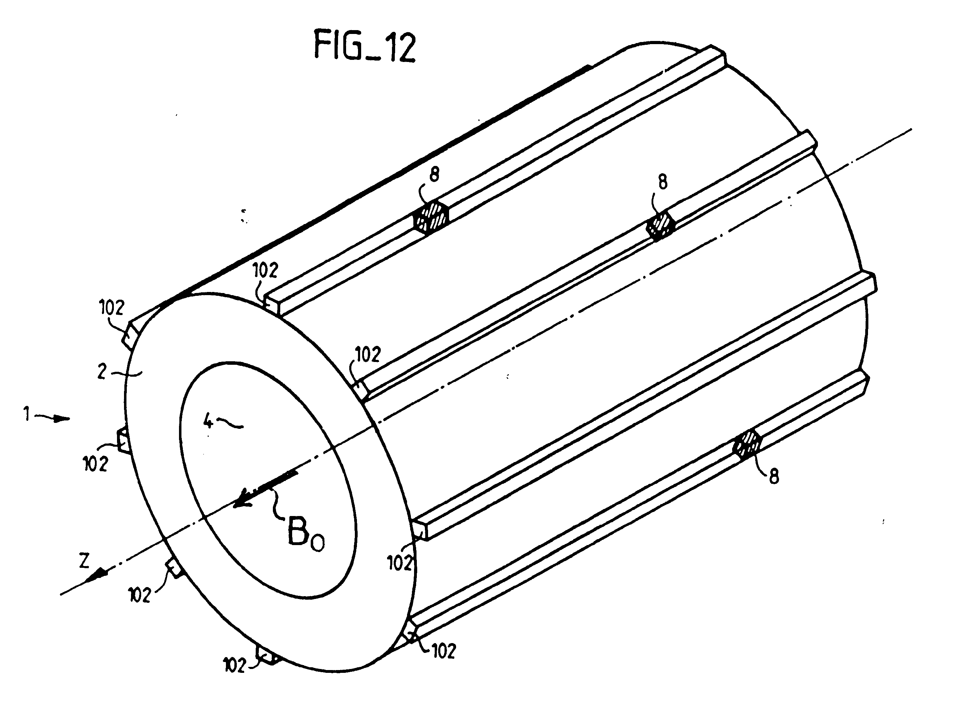

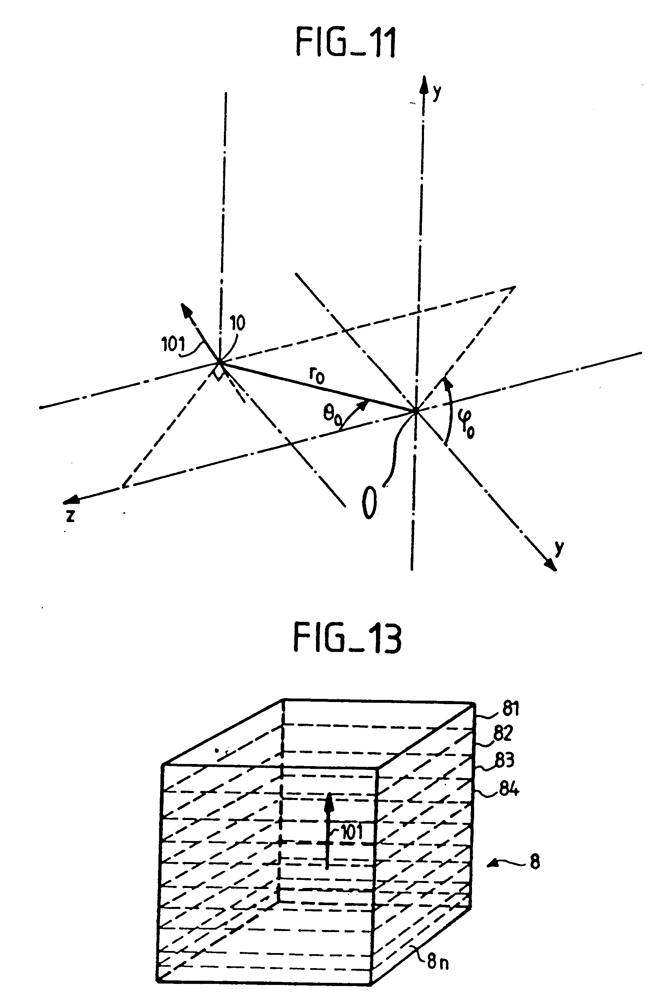

Sur la figure 13, on peut voir un exemple de réalisation d'aimants permanents 8 susceptibles d'être mis en oeuvre dans le dispositif selon la présente invention. Les aimants 8 susceptibles d'être mis en oeuvre dans le dispositif selon la présente invention comportent une pluralité de couches 81,82, jusqu'à 8n. Dans l'exemple, non limitatif, illustré sur la figure 9, n est égal à 10. Ainsi, il est possible, pour réaliser un aimant 8 d'utiliser autant que l'on veut de couches magnétiques, par exemple en samarium-cobalt ou en fer-néodyme-bore, qu'il n'est nécessaire pour obtenir une amplitude d'aimantation désirée. Une fois l'aimantation atteinte on remplit les couches ne devant pas contribuer à l'aimantation par des matériaux non magnétiques, comme par exemple de l'aluminium ou du plastique. Il est bien entendu que les couches magnétiques ne sont pas nécessairement consécutives mais permettent aussi d'être séparés par des couches non magnétiques de remplissage. Avantageusement, l'aimantation 101 est perpendiculaire à l'une des faces du cube 8.

Ainsi, il est possible de réaliser en usine une grande quantité d'aimants 8 ayant diverses valeurs nécessaires pour réaliser des corrections. Sur site, où on veut réaliser les corrections, on n'a pas besoin de modifier les aimants 8 qui constituent des incréments des corrections quantifiées. On utilise un nombre plus ou moins important d'aimants 8 ayant diverses aimantations selon la correction à apporter. Dans la mesure où les aimants 8 sont des pièces standards les aimants 8 dont on n'a pas eu besoin sont utilisés pour des corrections sur un site différent.

L'invention n'est pas limitée à la correction d'inhomogénéité de champ magnétique. Les aimants 8 peuvent apporter toute correction nécessaire

L'invention s'applique à la modification d'un champ magnétique. L'invention s'applique principalement à la correction d'inhomogénéité d'un champ magnétique d'un aimant utilisé en imagerie par résonance magnétique nucléaire.

## Revendications

1. Dispositif d'imagerie par résonance magnétique nucléaire, comportant des ouvertures (102) à section polygonale permettant l'introduction d'aimants permanents de correction d'inhomogénéité de champ magnétique, caractérisé par le fait que les ouvertures (102) ont une section carrée.

2. Dispositif selon la revendication 1, caractérisé par le fait qu'il comporte des aimants permanents parallélépipèdiques (8) logés dans les ouvertures (102).

3. Dispositif selon la revendication 2, caractérisé par le fait que les aimants (8) sont des cubes susceptibles de prendre six orientations à l'intérieur des ouvertures (102).

4. Dispositif selon l'une quelconque des revendications 1 à 3 caractérisé par le fait qu'il comporte en outre des bobinages de correction d'homogénéité de champ magnétique.

5. Procédé de correction d'inhomogénéité d'un champ magnétique dans une région d'espace d'un dispositif selon l'une des revendications 1 à 4, caractérisé par le fait qu'il comporte les étapes suivantes :
   - on mesure le champ magnétique en des points d'intérêt ;
   - on calcule des corrections apportées par des aimants permanents parrallélépipèdiques placés à l'intérieur dudit volume de l'espace et on choisit la configuration donnant le champ le plus homogène ;
   - on introduit des aimants à section carrée dans des ouvertures à section carrée selon une orientation donnée de façon à réaliser la configuration calculée et,
   - on fixe les aimants dans cette position.

6. Procédé selon la revendication 5, caractérisé par le fait que les aimants (8) ont une forme cubique.

7. Procédé selon la revendication 5 ou 6 caractérisé par le fait que l'étape de calcul comprend les phases suivantes :
   - on calcule l'expression analytique du champ mesuré ;
   - on calcule les expressions analytiques des champs produits par les aimants de correction en fonction de leur configuration ;

- on choisit la configuration pour laquelle la différence des expressions analytiques du champ mesuré et du champ idéal recherché est égale en valeur absolue et de signe contraire à l'expression analytique des champs de correction.

8. Procédé selon l'une quelconques des revendications 5 à 7, caractérisé par le fait qu'on utilise en outre des bobinages pour effectuer des corrections d'inhomogénéité de champ magnétique.

9. Procédé selon la revendication 8, caractérisé par le fait qu'on utilise les aimants (8) permanents pour effectuer des corrections radiales et les bobinages pour effectuer des corrections axiales.

10. Procédé selon l'une quelconque des revendications 5 à 9 caractérisé en ce que lesdits aimants permanents sont des aimants (8) de grande précision d'amplitude et d'orientation du moment magnétique, obtenus en empilant des couches (81, 82, ..., 8n) de matériau magnétique, et de matériau non magnétique, pour obtenir le moment magnétique désiré, dans un volume prédéterminé.

11. Procédé selon la revendication 10, caractérisé par le fait que ledit aimant permanent (8) est un cube dont l'aimantation des couches magnétiques est parallèle à une arête du cube.

**Patentansprüche**

1. Vorrichtung zur Bilderzeugung mittels magnetischer Kernresonanz mit Öffnungen (102) polygonalen Querschnitts, die das Einführen von Permanentmagneten zur Korrektur der Inhomogenität des magnetischen Feldes erlauben, dadurch gekennzeichnet, daß die Öffnungen (102) einen viereckigen Querschnitt aufweisen.

2. Vorrichtung nach Anspruch 1, dadurch gekennzeichnet, daß sie Permanentmagnete (8) in Form eines Parallelepipeds umfaßt, die in den Öffnungen (102) aufgenommen sind.

3. Vorrichtung nach Anspruch 2, dadurch gekennzeichnet, daß die Magnete (8) Würfel sind, die im Inneren der Öffnungen (102) sechs Orientierungen einnehmen können.

4. Vorrichtung nach einem der Ansprüche 1 bis 3, dadurch gekennzeichnet, daß sie außerdem Spulen zur Korrektur einer Inhomogenität des magnetischen Feldes umfaßt.

5. Verfahren zur Korrektur der Inhomogenität eines magnetischen Feldes in einem räumlichen Bereich einer Vorrichtung nach einem der Ansprüche 1 bis 4, dadurch gekennzeichnet, daß es die folgenden Schritte umfaßt:
   - man mißt das magnetische Feld an den interessierenden Stellen;
   - man berechnet die Korrekturen, die von den die Form eines Parallelepipeds aufweisenden Permanentmagneten herbeigeführt werden, die im Inneren des Raumvolumens angeordnet sind und man wählt die Konfiguration, die das am meisten homogene Feld liefert;
   - man führt Magnete mit viereckigem Querschnitt in Öffnungen mit viereckigen Querschnitt gemäß einer vorgegebenen Orientierung so ein, daß die berechnete Konfiguration realisiert wird und
   - man legt die Magnete in dieser Lage fest.

6. Verfahren nach Anspruch 5, dadurch gekennzeichnet, daß die Magnete (8) eine kubische Form aufweisen.

7. Verfahren nach Anspruch 5 oder 6, dadurch gekennzeichnet, daß der Rechenschritt die folgenden Stufen umfaßt:
   - man berechnet den analytischen Ausdruck des gemessenen Feldes;
   - man berechnet die analytischen Ausdrücke der von den Korrekturmagneten Felder in Abhängigkeit von deren Konfiguration erzeugten Felder;
   - man wählt die Konfiguration, für die die Differenz der analytischen Ausdrücke des gemessenen Feldes und des ermittelten idealen Feldes einen gleichen absoluten Wert wie und ein entgegengesetztes Vorzeichen zum analytischen Ausdruck der Korrekturfelder besitzt.

8. Verfahren nach einem der Ansprüche 5 bis 7, dadurch gekennzeichnet, daß außerdem Spulen eingesetzt werden, um Korrekturen der Inhomogenität des magnetischen Feldes durchzuführen.

9. Verfahren nach Anspruch 8, dadurch gekennzeichnet, daß man die Permanentmagnete (8) zur Durchführung von radialen Korrekturen und die Spulen zur Durchführung von axialen Korrekturen verwendet.

10. Verfahren nach einem der Ansprüche 5 bis 9, dadurch gekennzeichnet, daß die Permanentmagnete Magnete (8) hoher Genauigkeit bezüglich der Amplitude und der Orientierung des magnetischen Moments sind und dadurch erhalten werden, daß Lagen (81, 82, ..., 8n) aus magnetischem Material und aus nichtmagnetischem Material übereinander gestapelt werden, um das gewünschte magnetische Moment in einem vorbestimmten Volumen zu erhalten.

11. Verfahren nach Anspruch 10, dadurch gekennzeichnet, daß der Permanentmagnet (8) ein Würfel ist, bei dem die Magnetisierung der magnetischen Lagen parallel zu einer Kante des Würfels ist.

**Claims**

1. Nuclear magnetic resonance imaging device, comprising apertures (102) of polygonal cross section, enabling permanent magnets for the correction of non-homogeneity of the magnetic field to be introduced, characterized by the fact that the apertures (102) are of square cross section.

2. Device in accordance with claim 1, characterized by the fact that it comprises parallelopipedal permanent magnets (8) lodged in the apertures (102).

3. Device in accordance with claim 2, characterized by the fact that the magnets (8) are cubes capable of assuming six orientations inside the apertures (102).

4. Device in accordance with any one of claims 1 to 3 characterized by the fact that it also comprises windings for the correction of non-homogeneity of the magnetic field.

5. Process for correcting the non-homogeneity of a magnetic field in a spatial region of a device according to any one of claims 1 to 4, characterized by the fact that it comprises the following stages:
   -- the magnetic field is measured at points of interest;
   -- corrections provided by parallelopipedal permanent magnets situated inside the said volume of the space are calculated and that configuration is selected which provides the most homogeneous field;
   -- magnets of square cross section are introduced into apertures of square cross section in accordance with a certain given orientation in such a manner as to provide the configuration calculated: and
   -- the magnets are fixed in this position.

6. Process in accordance with claim 5, characterized by the fact that the magnets (8) are of cubic cross section.

7. Process in accordance with claim 5 or 6, characterized by the fact that the calculation stage comrpises the following phases:
   -- the analytical expression of the field measured is calculated;
   -- the analytical expressions of the fields produced by the correction magnets are calculated as a function of their configuration;
   -- that configuration is selected for which the difference of the analytical expressions, as between the field measured and the ideal field desired, is equal as an absolute value and of opposite sign to the analytical expression of the correction fields.

8. Process in accordance with any one of claimes 5 to 7, characterized by the fact that the windings likewise are utilized for the purpose of non-homogeneity corrections of the magnetic field.

9. Process in accordance with claim 8, characterized by the fact that use is made of the permanent magnets (8) in order to perform radial corrections and of the coils in order to perform axial corrections.

10. Process in accordance with any of claims 5 to 9, characterized by the fact that said permanent magnets are permanent magnets (8) of high amplitude precision and of high orientation precision of the magnetic moment, obtained by piling layers (81, 82, ... 8n) of magnetic material and of non-magnetic material, in order to obtain the desired magnetic moment, in a preselected volume.

11. Process in accordance with claim 10, characterized by the fact that the said permanent magnets (8) is a cube of which the magnetization of the magnetic layers is parallel to an edge of the cube.

FIG_1

FIG_2

FIG_3

FIG_4

FIG_5

FIG_6

# FIG_7

# FIG_8

## FIG_9

## FIG_10

FIG_12

# FIG_11

# FIG_13